# EUROPÄISCHE PATENTSCHRIFT

(11) **EP 0 892 432 B1**
(45) Veröffentlichungstag und Bekanntmachung des Hinweises auf die Patenterteilung: **08.12.2004**
(21) Anmeldenummer: 98105813.4
(22) Anmeldetag: 30.03.1998
(51) Int. Cl.: H01L 23/498, H01L 25/16, H01R 12/32, H05K 3/30

(54) **Anschlussanordnung für eine SMD - fähige Hybridschaltung**
Pin arrangement for an SMD mountable hybrid circuit
Agencement de broche pour un circuit hybride montable par la méthode SMD

(30) Priorität: 24.04.1997 DE 19717384
(43) Veröffentlichungstag der Anmeldung: 20.01.1999
(73) Patentinhaber: TYCO Electronics Logistics AG, 9323 Steinach (CH)
(72) Erfinder: Rehnelt, Karl, 81249 München (DE); Templin, Frank, 10367 Berlin (DE)
(74) Vertreter: Klunker . Schmitt-Nilson . Hirsch

(56) Entgegenhaltungen:
- EP-A- 0 631 312
- WO-A-94/03913
- WO-A-95/11523
- WO-A-96/13966
- US-A- 5 142 263

## Beschreibung

Die Erfindung betrifft eine Anschlußanordnung für eine SMD-fähige Hybridschaltung.

Hybrid- oder Schichtschaltungen sind elektronische Subbaugruppen, bei denen planare Leiterbahnstrukturen und passive Bauelemente, insbesondere Widerstände, mittels spezieller Schichttechnologien auf ein Keramiksubstrat aufgebracht werden, wobei diese planaren Strukturen auf dem gemeinsamen Keramiksubstrat mit weiteren Bauelementen, beispielsweise IC's oder Relais, verschaltet beziehungsweise hybridiert werden. Diese weiteren Bauelemente sind üblicherweise oberflächenmontierbar, das heißt sie werden in der bekannten SMD-(surface mounted devices) Technik auf Anschlußflecken auf der Hybridschaltung aufgesetzt und dort, meistens durch Reflow-Löten, verlötet.

Im Zuge der Senkung des Fertigungs- und Bestückaufwandes in der Leiterplattenfertigung wird der vollständige Übergang zur Oberflächenmontagetechnologie angestrebt. Deshalb sollte eigentlich die Hybridschaltung als ganzes selbst wiederum SMD-fähig sein. Zur Erzielung einer hohen Integrationsdichte werden allerdings Hybridschaltungen heute meist als single-in-line Subbaugruppen in Leiterplatten eingelötet. Um den in der dritten Dimension gegebenen Raum auszunutzen, werden sie also senkrecht zur Leiterplatte beziehungsweise zum Substrat mit nur einer Reihe von Anschlüssen montiert. Single-in-line Hybridbaugruppen werden jedoch bisher ausschließlich mittels Durchsteckmontage mit der Mutterplatine (Substrat) verbunden und sind mittlerweile nahezu das letzte nicht in SMD-Technik verfügbare Bauelement.

Probleme bei der Realisierung von senkrecht montierten SMD-fähigen Hybridbaugruppen liegen vor allem in der Planaritätsforderung der Anschlußpins (so ist beispielsweise eine Koplanarität von 0,1 mm bei einem Lotpastendruck von 0,15 mm Dicke zu fordern), aber auch in mechanischen Anforderungen an die Anschlußpins hinsichtlich Schwing- und Stoßbelastung im Gerät, insbesondere beim Transport. Außerdem muß die Hybridschaltung selbst vom Aufbau her den erhöhten Belastungen bei der SMD-Montage stand halten und diese sollte natürlich möglichst keinen erhöhten Fertigungsaufwand, beispielsweise zusätzliche Sicherungsmaßnahmen während des Lötens, bedingen.

Das Dokument WO-A-9 511 523 zeigt in den Abb. 29 und 29A eine Anschlussanordnung, die für eine SMD-fähige Hybridschaltung geeignet ist, mit mehreren als metallische Stanzbiegeteile ausgeführten Anschlusspins, die an jeweils einem ihrer beiden Längsenden einen als Aufstandsfläche ausgebildeten Abschnitt aufweisen, wobei die Aufstandsfläche jedes Anschlusspins beim Bestücken und Verlöten der Hybridschaltung auf einem Substrat eine zu diesem Substrat koplanare Aufstandsebene bilden,
die außerdem zwischen ihren beiden Längsenden einen Abschnitt aufweisen, der parallel zur Aufstandsebene, also ihr gegenüber erhöht, verläuft,
wobei Mittel vorgesehen sind, um die Hybridschaltung senkrecht zur Aufstandsebene über dem jeweiligen erhöhten Abschnitt so zu befestigen, dass die jeweiligen sich seitlich zur Hybridschaltung erstreckenden Abschnitte mit den Aufstandsflächen eine Standbasis der Anschlussanordnung beim Bestücken und Verlöten der Hybridschaltung bilden.

Der Erfindung liegt die Aufgabe zugrunde, eine Anschlußanordnung für eine single-in-line montierbare, SMD-fähige Hybridschaltung anzugeben.

Diese Aufgabe wird gelöst durch eine Anschlußanordnung der eingangs genannten Art,
- mit mindestens zwei als metallische Stanzbiegeteile ausgeführten, im wesentlichen rechteckig flächigen Anschlußpins,
- die an ihren beiden Längsenden jeweils einen als Aufstandsfläche ausgebildeten Abschnitt aufweisen, wobei die beiden Aufstandsflächen jedes Anschlußpins beim Bestücken und Verlöten der Hybridschaltung auf einem Substrat eine zu diesem Substrat koplanare Aufstandsebene bilden,
- die außerdem zwischen ihren beiden Längsenden einen Befestigungsabschnitt aufweisen, der parallel zur Aufstandseben, also ihr gegenüber erhöht, verläuft,
- und bei denen Mittel vorgesehen sind, um die Hybridschaltung senkrecht zur Aufstandsebene auf dem jeweiligen Befestigungsabschnitt so zu befestigen, daß die sich seitlich zur Hybridschaltung erstreckenden Abschnitte mit den Aufstandsflächen eine Standbasis der Anschlußanordnung beim Bestücken und Verlöten der Hybridschaltung bildet.

Durch die erfindungsgemäße Konstruktion der Anschlußpins mit zwei Seitenabschnitten und einem brückenartigen, hochgezogenen Mittelabschnitt, wobei Anschlußpin und senkrecht hochragende Hybridschaltung zusammen typischerweise eine umgedrehte T-Form aufweisen, wird einerseits erreicht, daß die Hybridschaltung ohne weitere Hilfsmittel von selbst auf dem Substrat steht und verlötet werden kann. Andererseits bewirkt die brückenartige Konstruktion eine ausreichende Elastizität und Belastbarkeit gegenüber Schwingungen bzw. Beschleunigungen sowie das Vorhandensein von zwei definierten Aufstandsflächen, deren Koplanarität nicht zuletzt durch die federnde Ausführung der Anschlußpins gewährleistet wird.

Weitere vorteilhafte Ausgestaltungen des Gegenstandes des Anspruchs 1 sind in Unteransprüchen angegeben.

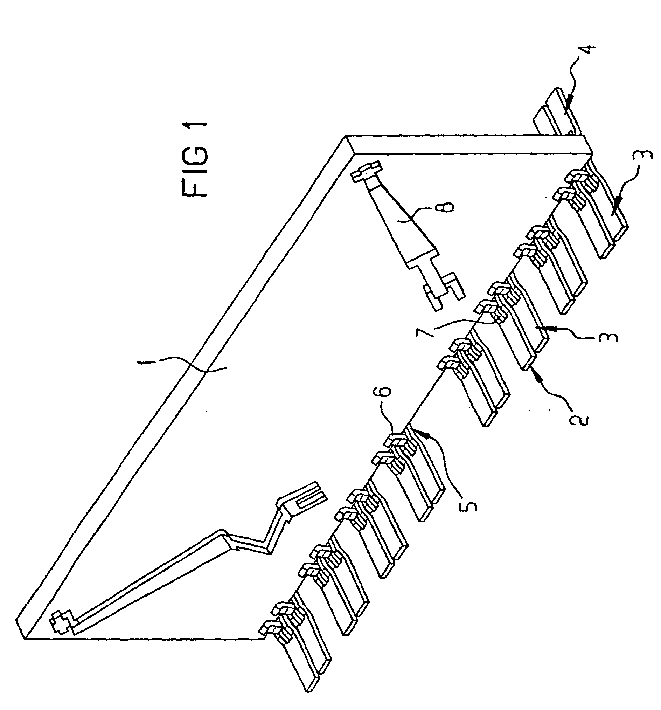

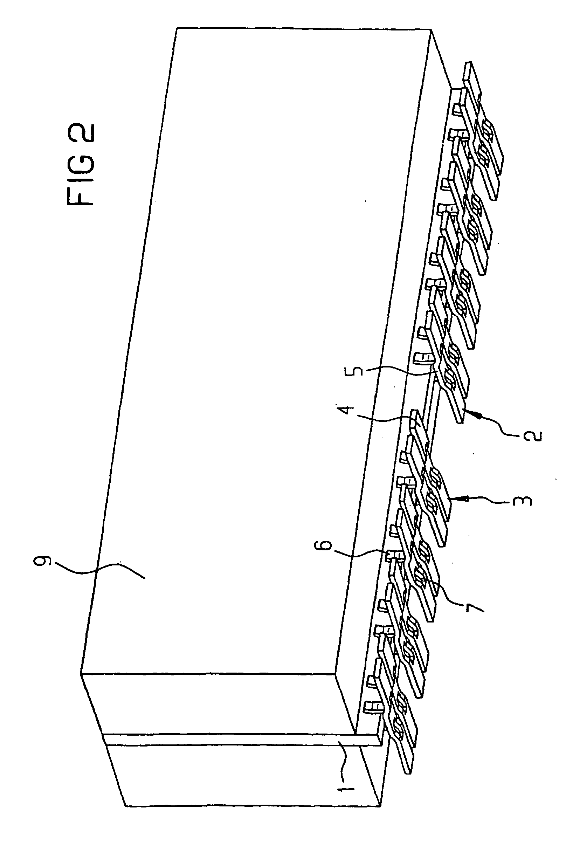

Die Erfindung wird im folgenden anhand eines in den Figuren der Zeichnung dargestellten Ausführungsbeispiels näher erläutert. Figur 1 und 2 zeigen in verschiedener Perspektive eine Ausführungsform einer erfindungsgemäßen Anschlußanordnung mit einer Hybridschaltung.

Die in der Zeichnung dargestellte Anschlußanordnung, oft auch Anschlußkamm genannt, besteht aus einer Anzahl von aus einem Blechbiegestanzteil hergestellten Anschlußpins 2, die jedoch nicht notwendig paarweise angeordnet sein müssen. Die Hybridschaltung 1 kann, wie dargestellt, beispielsweise zwischen hochgebogenen Zinken 6 eingeklemmt werden, so daß sie insgesamt senkrecht zur gemeinsamen Aufstandsebene der Anschlußpins und damit auch senkrecht zur Substrat- bzw. Leiterplattenebene angeordnet ist. In Figur 1 sind auf der Hybridschaltung 1 zwei Thermosicherungen 8 dargestellt, während die übrigen diskreten Bauelemente beziehungsweise die vorhandenen Schichtstrukturen nicht dargestellt sind. Ebenso ist in Figur 2 der Einfachheit halber lediglich ein abstrakter Bauelementeraum 9 auf beiden Seiten der Hybridschaltung 1 angedeutet.

Die durch die Zinkenbildung entstandene Lochkontur 7, vgl. Figur 1, wirkt positiv auf den Lötfluß beim Verlöten der Aufstandsflächen 3 und 4. Es entstehen weitgehend lunkerfreie und damit haltbarere Lötstellen. Die Anzahl der Anschlußpins 2 richtet sich primär nach der Polzahl der Hybridschaltung 1, da die Stabilität der Standbasis üblicherweise bereits durch zwei allerdings nicht zu nah benachbarte Anschlußpins 2 gewährleistet ist. Die Abmessungen der Seitenabschnitte sind im wesentlichen unkritisch, sie können beispielsweise bei Hybridschaltungsabmessungen von einigen Zentimetern etwa 8 mm x 0,9 mm betragen. Je nach Platzbedarf auf dem Substrat können die Seitenabschnitte mit den Aufstandsflächen 3 und 4 durch Abschneiden ein- oder beidseitig mehr oder weniger verkürzt werden. Wenn die Standbasis durch mindestens zwei vollständige Anschlußpins 2 gewährleistet ist, können einzelne Anschlußpins 2 auch mit nur einseitig vorhandener Aufstandsfläche ausgeführt sein. Es ist außerdem möglich, die Anschlußanordnung durch einen unterhalb des Befestigungsabschnitts 5 gesetzten Kleberpunkt beim Bestücken und Verlöten auf dem Substrat zusätzlich zu fixieren.

Mit der erfindungsgemäßen Anschlußanordnung können ohne weiteres die geforderten elektrischen Parameter hinsichtlich Strombelastung und Übergangswiderstand erreicht werden. Die Aufbautechnologie der Hybridschicht und der Lote auf der Hybridschaltung selbst sind so ausgeführt, daß sie den erhöhten Belastungen bei der SMD-Montage stand halten. Die Anschlußanordnung ist fertigungstechnisch großserientauglich. Die entsprechenden Hybridschaltungen die sehr vielfältig, beispielsweise in einem Widerstandsnetzwerk oder in einem AC/DC-Wandler einsetzbar sind, können vollautomatisch aus der Verpackung heraus bestückt und verlötet werden.

## Patentansprüche

1. Anschlußanordnung für eine SMD-fähige Hybridschaltung
- mit mindestens zwei als metallische Stanzbiegeteile ausgeführten, im wesentlichen rechteckig flächigen Anschlußpins (2),
- die an ihren beiden Längsenden jeweils einen als Aufstandsfläche (3, 4) ausgebildeten Abschnitt aufweisen, wobei die beiden Aufstandsflächen (3, 4) jedes Anschlußpins (2) beim Bestücken und Verlöten der Hybridschaltung (1) auf einem Substrat eine zu diesem Substrat koplanare Aufstandsebene bilden,
- die außerdem zwischen ihren beiden Längsenden einen Befestigungsabschnitt (5) aufweisen, der parallel zur Aufstandsebene, also ihr gegenüber erhöht, verläuft,
- und bei denen Mittel (6) vorgesehen sind, um die Hybridschaltung (1) senkrecht zur Aufstandsebene auf dem jeweiligen Befestigungsabschnitt (5) so zu befestigen, daß die sich seitlich zur Hybridschaltung (1) erstreckenden Abschnitte mit den Aufstandsflächen (3, 4) eine Standbasis der Anschlußanordnung beim Bestücken und Verlöten der Hybridschaltung (1) bilden.

2. Anschlußanordnung nach Anspruch 1,
**dadurch gekennzeichnet,**
**daß** die Abschnitte mit den Aufstandsflächen (3, 4) je nach Platzbedarf auf dem Substrat unterschiedlich lang ausgebildet sind.

3. Anschlußanordnung nach Anspruch 1 oder 2,
**dadurch gekennzeichnet,**
**daß** die Anschlußanordnung durch einen unterhalb des Befestigungsabschnitts (5) setzbaren Kleberpunkt beim Bestücken und Verlöten auf dem Substrat zusätzlich fixierbar ist.

## Claims

1. A pin configuration for an SMD-mountable hybrid circuit
having at least two substantially rectangular flat connection pins (2) executed as metallic punched and bent components,
which exhibit a portion in the form of a support surface (3, 4) at each of their two longitudinal ends, the two support surfaces (3, 4) of each connection pin (2) forming a support plane coplanar with a substrate when the hybrid circuit (1) is assembled and soldered on said substrate,
which additionally comprise between their two longitudinal ends a fastening portion (5), which extends parallel to the support plane, i.e. raised relative thereto,
and which are provided with means (6) for fastening the hybrid circuit (1) perpendicularly to the support plane on the respective fastening portion (5), in such a way that the portions with the support surfaces (3, 4) extending to the sides of the hybrid circuit (1) form a stand base for the pin configuration during assembly and soldering of the hybrid circuit (1).

2. A pin configuration according to claim 1,
**characterised in that**
the portions with the support surfaces (3, 4) are of differing lengths, depending on the space requirements on the substrate.

3. A pin configuration according to claim 1 or claim 2,
**characterised in that**
the pin configuration may be additionally fixed during assembly and soldering on the substrate by a spot of adhesive which may be positioned beneath the fastening portion (5).

## Revendications

1. Dispositif de raccordement pour un circuit hybride à montage en surface (SMD)
comportant au moins deux broches de connexion sous forme d'éléments métalliques estampés et pliés, ayant pour l'essentiel une forme rectangulaire plane (2),
comportant respectivement au niveau de leurs deux extrémités longitudinales une section sous forme d'une surface d'appui (3, 4), les deux surfaces d'appui (3, 4) de chaque broche de raccordement (2) formant, lors de l'équipement et du soudage du circuit hybride (1) sur un substrat, un plan d'appui coplanaire à ce substrat,
comportant en outre entre leurs deux extrémités longitudinales une section de fixation (5), s'étendant parallèlement au plan d'appui, et donc de manière surélevée par rapport à celui-ci,
et comportant des moyens (6) destinés à fixer le circuit hybride (1) de manière perpendiculaire au plan d'appui sur la section de fixation correspondante (5), de sorte que les sections s'étendant latéralement par rapport au circuit hybride (1) forment avec les surfaces d'appui (3, 4) une base de support du dispositif de raccordement lors de l'équipement et du soudage du circuit hybride (1).

2. Dispositif de raccordement selon la revendication 1, **caractérisé en ce que**
les sections comportant les surfaces d'appui (3, 4) ont une longueur différente sur le substrat en fonction de l'encombrement correspondant.

3. Dispositif de raccordement selon les revendications 1 ou 2, **caractérisé en ce que**
le dispositif de raccordement peut être fixé en plus par un point de collage pouvant être appliqué au-dessous de la section de fixation (5) lors de l'équipement et du soudage sur le substrat.
